# EUROPEAN PATENT APPLICATION

(11) **EP 3 389 180 A1**
(43) Date of publication of application: **17.10.2018**
(21) Application number: 17738195.1
(22) Date of filing: 13.01.2017
(51) Int. Cl.: H02S 30/20, H01L 31/048

(54) **SOLAR CHARGER**

(30) Priority: 13.01.2016 CN 201620031371 U
(71) Applicant: Beijing Apollo Ding Rong Solar Technology Co., Ltd., Beijing 100176 (CN)
(72) Inventor: WANG, Jicun, Beijing 100176 (CN); XIA, Ping, Beijing 100176 (CN); CHENG, Xiaolong, Beijing 100176 (CN); MA, Siyao, Beijing 100176 (CN); WANG, Yuefu, Beijing 100176 (CN); GAO, Yanlei, Beijing 100176 (CN); ZHANG, Yu, Beijing 100176 (CN)
(74) Representative: D'Halleweyn, Nele Veerle Trees Gertrudis
(86) International application number: PCT/CN2017/071115
(87) International publication number: WO 2017/121382

(57) **Abstract**

A portable solar charger includes: a charger body (1) formed by a first flexible protection film layer (31) through packaging; a thin-film solar cell assembly (2) fixedly arranged on an inner surface of the expanded charger body (1); a power output device (4) and a wire (5). A second flexible protection film layer (32) is packaged on the thin-film solar cell assembly (2), and sequentially includes an upper surface layer (321) and an adhesive bonding layer (322) from top to bottom. A third flexible protection film layer is packaged on the remaining area of the inner surface of the expanded charger body (1) other than the area occupied by the thin-film solar cell assembly (2), and sequentially includes an upper surface layer, an adhesive bonding layer and a lower surface layer from top to bottom. The first flexible protection film layer (31) sequentially includes an adhesive bonding layer (311) and a lower surface layer (312) from top to bottom. The power output device (4) is configured to output electric energy converted by the thin-film solar cell assembly (2). The wire (5) is configured to connect the thin-film solar cell assembly (2) to the power output device (4).

## Description

### Technical Field

The application relates to, but is not limited to, the technical field of semiconductors, in particular to a solar charger.

### Background

Recently a solar charger in the market generally includes a solar photovoltaic assembly and a voltage output unit. Such a solar charger converts solar radiation into electrical energy through the solar photovoltaic assembly, and then generates stable direct current or alternating current output through a current conversion device to supply power to various loads. For example, Chinese patent document CN103997090A discloses a foldable solar mobile power source which includes a solar panel, a rotating shaft, a housing, a storage battery, a photovoltaic charging controller and an AC power socket. The solar panel is movably connected with the housing through the rotating shaft; the solar panel is electrically connected with the photovoltaic charging controller and the storage battery sequentially; the storage battery and the photovoltaic charging controller are installed in the housing; and the AC power socket is positioned on the side wall of the housing. The solar panel can rotate by means of the rotating shaft. When being charged with solar power, the solar panel is rotated to the outside of the housing, and when the charging is finished and the charger is in use, the solar panel can be rotated into an empty groove inside the housing, thus effectively avoiding damage to the solar panel.

The existing problem is that the solar mobile power source includes a solar panel, a rotating shaft, a housing, a storage battery, a photovoltaic charging controller and an AC power socket, which causes the solar mobile power source complex in structure, high in manufacturing cost and large in volume. In addition, the conversion efficiency of the solar panels which convert solar power to electric energy is relatively low. Also, the solar photovoltaic panels are generally inflexible or the flexibility thereof is low, which causes the panels cannot be folded or curled, or the solar cells are easily damaged after the panels being folded or curled. Moreover, the weight of solar photovoltaic panel is relatively high, which makes the solar mobile power source inconvenient to take along.

### Summary

Therefore, in order to solve the problems, i.e., the solar charger is complex in structure, large in volume, and cannot be folded and curled, or the solar cell is easily damaged after the solar charger being folded and curled, which cause it inconvenient to take along and low efficiency in converting solar energy into electric energy, this application provides a solar charger which is simple in structure, small in volume, foldable and flexional, and high in efficiency in converting solar energy into electric energy.

This application provides a solar charger including:
a charger body formed by a first flexible protection film layer through packaging;
a thin-film solar cell assembly fixedly arranged on an inner surface of the expanded charger body;
a power output device configured to output the electric energy converted by the thin-film solar cell assembly; and
a wire configured for connecting the thin-film solar cell assembly and the power output device;
wherein a second flexible protection film layer is packaged on the thin-film solar cell assembly and includes, sequentially and from the top to the bottom, an upper surface layer, an adhesive bonding layer, a water barrier film and an adhesive bonding layer, and a third flexible protection film layer is packaged on the remaining area of the inner surface of the expanded charger body expect for the area occupied by the thin-film solar cell assembly, and includes, sequentially and from the top to the bottom, an upper surface layer, an adhesive bonding layer and a lower surface layer.

Optionally, the first flexible protection film layer includes, sequentially and from the top to the bottom, an adhesive bonding layer and a lower surface layer.

Optionally, the upper surface layer is an ETFE layer, the lower surface layer is a waterproof cloth, and the adhesive bonding layer is an EVA layer.

Optionally, the thickness of the upper surface layer of the second flexible protection film layer ranges from 0.01 to 0.2 mm.

Optionally, the thickness of the adhesive bonding layer ranges from 0.2 to 0.3 mm.

Optionally, the thickness of the lower surface layer ranges from 0.1 to 0.2 mm.

Optionally, the power output device includes a junction box within which an integrated circuit board is arranged for controlling the electric energy converted by the thin-film solar cell assembly so that the output voltage of the solar charger meets the requirements of a load, and the junction box is provided with at least one USB interface for connecting with the load.

Optionally, the integrated circuit board is provided with at least one indicator lamp which is capable of indicating sunlight intensity.

Optionally, the wire is located between the first flexible protection film layer and the third flexible protection film layer and penetrates the adhesive bonding layer and the lower surface layer of the first flexible protection film layer to connect to the power output device.

Optionally, the thin-film solar cell assembly includes at least one CIGS thin-film solar cell, and the CIGS thin-film solar cell includes, sequentially and from the top to the bottom, a water barrier film, a CIGS thin-film solar cell chip and a water barrier film.

Optionally, at least one through hole is arranged on the charger body for hanging and connecting.

In order to solve the above technical problems, this application also provides a solar charger including:
a charger body formed by a first flexible protection film layer;
a thin-film solar cell assembly arranged on an inner surface of the expanded first flexible protection film layer;
a power output device configured to output the electric energy converted by the thin-film solar cell assembly;
a wire configured for connecting the thin-film solar cell assembly and the power output device; and
a transparent flexible protection film layer configured to cover at least an upper surface of the thin-film solar cell assembly and fixed to the first flexible protection film layer.

Optionally, the solar charger further includes:
a windowed flexible protection film layer provided with a window in the middle thereof to expose the upper surface of the thin-film solar cell assembly;
the portion of the windowed flexible protection film layer other than the window is fixed on the first flexible protection film layer, and the transparent flexible protection film layer is arranged to cover the upper surface of the thin-film solar cell assembly and is fixed on the windowed flexible protection film layer; or
the windowed flexible protection film layer is configured to fix the portion of the transparent flexible protection film layer extending beyond the upper surface of the thin-film solar cell assembly between the windowed flexible protection film layer and the first flexible protection film layer.

Optionally, the first flexible protection film layer includes, sequentially and from the top to the bottom, an adhesive bonding layer and a lower surface layer; and the transparent flexible protection film layer includes, sequentially and from the top to the bottom, an upper surface layer and an adhesive bonding layer, and is fixed on the lower surface layer of the first flexible protection film layer by said adhesive bonding layer or the adhesive bonding layer of the first flexible protection film layer.

Optionally, the first flexible protection film layer includes, sequentially and from the top to the bottom, an adhesive bonding layer and a lower surface layer; and the transparent flexible protection film layer includes, sequentially and from the top to the bottom, an upper surface layer and an adhesive bonding layer;
the windowed flexible protection film layer is fixed on the lower surface layer of the first flexible protection film layer by the adhesive bonding layer of the first flexible protection film layer, and the transparent flexible protection film layer is fixed on the thin-film solar cell assembly and the windowed flexible protection film layer by the adhesive bonding layer thereof; or
the transparent flexible protection film layer is fixed on the thin-film solar cell assembly and the lower surface layer of the first flexible protection film layer by the adhesive bonding layer thereof, and the portion of the transparent flexible protection film layer extending beyond the upper surface of the thin-film solar cell assembly is fixed between the windowed flexible protection film layer and the first flexible protection film layer.

Optionally, the upper surface layer of the transparent flexible protection film layer is an ETFE layer or ECTFE layer, the lower surface layer of the first flexible protection film layer and a windowed flexible protection film layer are waterproof cloths, the adhesive bonding layers of the first flexible protection film layer and the transparent flexible protection film layer are EVA layers, and the upper surface layer of the transparent flexible protection film layer is a layer provided with a plurality of recesses.

Optionally, the thickness of the upper surface layer of the transparent flexible protection film layer ranges from 0.01 to 0.2 mm, the thickness of the adhesive bonding layer of the transparent flexible protection film layer ranges from 0.2 to 0.3 mm, the thickness of the adhesive bonding layer of the first flexible protection film layer ranges from 0.2 to 0.3 mm, the thickness of the lower surface layer of the first flexible protection film layer ranges from 0.1 to 0.2 mm, and the thickness of the windowed flexible protection film layer ranges from 0.1 to 0.2 mm.

Optionally, the thin-film solar cell assembly includes at least one CIGS thin-film solar cell, and the CIGS thin-film solar cell includes, sequentially and from the top to the bottom, a water barrier film, a CIGS thin-film solar cell chip and a water barrier film, or includes, sequentially and from the top to the bottom, a water barrier film, an adhesive bonding layer, a CIGS thin-film solar cell chip, an adhesive bonding layer and a water barrier film.

Compared with the prior art, the technical schemes provided by the embodiments of the application have the following advantages.
1. The solar charger provided by the embodiment of the application greatly improves the conversion efficiency of converting solar energy into electric energy by adopting the thin-film solar cell assembly. The thin-film solar cell is light in weight and easy to take along. The charger body is formed by a first flexible protection film layer through packaging. The second flexible protection film layer and the third flexible protection film layer are flexible, and the thin-film solar cell assembly fixed on the inner surface of the charger body per se is also flexible, so that the portable solar charger of this application can be folded and curled to a smaller volume by the user and thus is very easy to take along. Furthermore, by the arrangement of the first, second and third flexible protection film layers, the thin-film solar cell assembly can be protected from damages caused by moisture, high temperature and ultraviolet light as well as mechanical and chemical damages, thus guaranteeing the reliability and stability of the solar charger of this application.
2. The solar charger provided by the embodiment of the application is provided with at least one indicator lamp on the integrated circuit board. The indicator lamp is capable of indicating the sunlight intensity, and can be used for guiding users.
3. The solar charger provided by the embodiment of the application is provided with a through hole on the charger body, so that the solar charger can be conveniently hung on a backpack or a satchel when the user goes out, thereby facilitating the user to take the solar charger along with him/her.

### Brief Description of Drawings

In order that the disclosure of this application can be more clearly understood, embodiments of this application will be described in further detail below in accordance with specific embodiments of this application and with reference to the accompanying drawings, in which:
Fig. 1 is a front view of a solar charger after being expanded according to an embodiment of the present application;
Fig. 2 is a back view of a solar charger after being expanded according to an embodiment of the present application;
Fig. 3 is a longitudinal sectional view of a thin-film solar cell assembly;
Fig. 4 is a longitudinal sectional view of a portion of a charger body including the thin-film solar cell assembly according to a first embodiment;
Fig. 5 is a longitudinal sectional view of a portion of a charger body including the thin-film solar cell assembly according to a second embodiment.

The reference numbers in the figures are as follows: 1 - charger body; 11 - through hole; 2 - thin-film solar cell assembly; 201 - water barrier film; 202 - thin-film solar cell chip; 203 - water barrier film; 32 - second flexible protection film layer; 321 - upper surface layer; 322 - adhesive bonding layer; 31 - first flexible protection film layer; 311 - adhesive bonding layer; 312 - lower surface layer; 4 - power output device; 41 - USB interface; 5 - wire; 3 - windowed flexible protection film layer; 201a - adhesive bonding layer, 203a - adhesive bonding layer.

### Detailed Description

The specific embodiments of the present application will be described in detail below with reference to the accompanying drawings. It should be understood that the specific embodiments described herein are only used to illustrate and explain the examples of this application and are not intended to limit the invention.

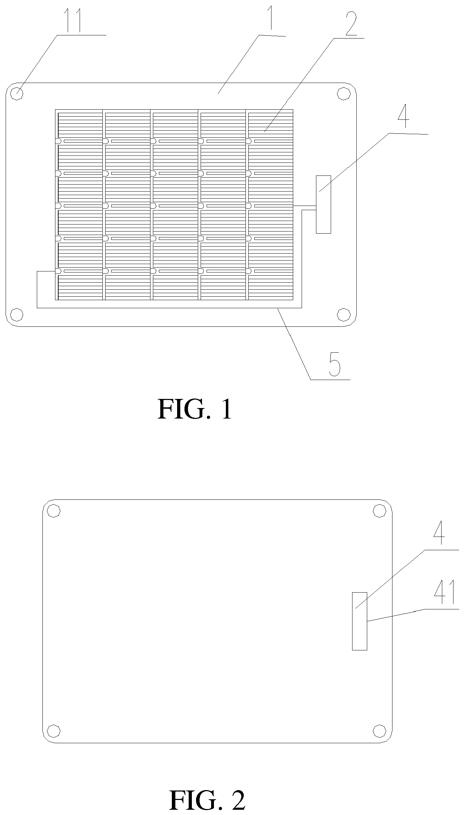

Fig. 1 shows the general technical disclosure of an embodiment, which provides a portable solar charger including a charger body 1, a thin-film solar cell assembly 2 for converting solar power into electrical energy, a power output device 4 for outputting the electrical energy converted by the thin-film solar cell assembly 2, and a wire 5.

The charger body 1 is formed through packaging by a first flexible protection film layer 31 which can be folded and curled. The charger body 1 can be configured to have a square, circular shape or other regular or irregular shapes. In this application, the specific shape of the charger body 1 is not limited to the embodiments. In an embodiment, the charger body 1 is square in shape. The thin-film solar cell assembly per se is flexible. Besides, the thin-film solar cell assembly has high conversion efficiency for converting solar energy into electric energy and the weight thereof is low. In this application, the thin-film solar cell assembly includes at least one CIGS thin-film solar cell. In this embodiment, the thin-film solar cell assembly includes one CIGS thin-film solar cell. The CIGS thin-film solar cell includes, sequentially and from the top to the bottom, a water barrier film 201, a CIGS thin-film solar cell chip 202 and a water barrier film 203. The CIGS thin-film solar cell chip 202 and the upper and lower water barrier films 201 and 203 are packaged into one piece. The CIGS thin-film solar cell chip 202 has good flexibility, can be folded and curled, and will not be damaged after being folded or curled. The water barrier films 201 and 203 arranged respectively on the upper side and lower side of the CIGS thin-film solar cell chip 202 are waterproofed and electrically insulated. The water barrier films are made of hot melt adhesive and are sticky. In this embodiment, the CIGS thin-film solar cell 2 is square in shape, and is bonded to the inner surface of the expanded charger body 1 through the adhesive water barrier film 203 positioned at the lower portion of the CIGS thin-film solar cell 2.

Optionally, in this embodiment, in order to improve the efficiency of converting solar energy into electric energy, the thin-film solar cell occupies most of the area of the inner surface of the charger body 1. Preferably the ratio of the area occupied by the thin-film solar cell to the area of said inner surface is 0.6: 1 to 0.8: 1, but this ratio is not limited to this. The ratio of the area occupied by the thin-film solar cell to the area of the inner surface of the charger body 1 can be further adjusted according to actual needs, for example, to 0.5: 1, 0.4: 1. In an embodiment, a second flexible protection film layer 32 is packaged on the thin-film solar cell assembly and includes, sequentially and from the top to the bottom, an upper surface layer 321 and an adhesive bonding layer 322. The upper surface layer 321 is preferably made of a transparent, waterproof, scratchproof, wear-resistant and weather-resistant material, such as an ETFE layer. The adhesive bonding layer 322 is preferably a hot melt adhesive layer such as an EVA layer. A third flexible protection film layer is packaged on the remaining area of the inner surface of the expanded charger body 1 expect for the area occupied by the thin-film solar cell assembly. The third flexible protection film layer includes, sequentially and from the top to the bottom, an upper surface layer, an adhesive bonding layer and a lower surface layer. Likewise, the upper surface layer is made of a transparent, waterproof, scratchproof, wear-resistant and weather-resistant material, such as an ETFE layer, and the adhesive bonding layer is a hot melt adhesive layer such as an EVA layer. The lower surface layer is made of an opaque, flexible and waterproofed material such as waterproof cloth. The upper surface layer of the third flexible protection film layer can be bonded to the upper surface layer of the second flexible protection film layer. In this application, the thickness of the upper surface layer may range from 0.01 to 0.2 mm, and the packaging process is difficult to perform if it is too thick. Optionally, in an embodiment, the thickness of the upper surface layer is 0.05 mm. The thickness of the adhesive bonding layer may range from 0.2 to 0.3 mm, and the adhesive property is not good enough and stripping is prone to occur if it is too thin. The thickness of the lower surface layer may range from 0.1 to 0.2 mm.

By the packaging of the first, second and third flexible protection film layers and the thin-film solar cell assembly, the portable solar charger of this application can be folded and curled, and the weight thereof is low, which make it easy to take along.

Optionally, the first flexible protection film layer 31 of an embodiment includes, sequentially and from the top to the bottom, an adhesive bonding layer 311 and a lower surface layer 312.

Likewise, the adhesive bonding layer 311 is a hot melt adhesive layer such as an EVA layer, and the lower surface layer 312 is made of an opaque, flexible and waterproofed material such as waterproof cloth. By the arrangement of the first, second and third flexible protection film layers, the thin-film solar cell assembly 2 can be protected from damages caused by moisture, high temperature and ultraviolet light as well as mechanical and chemical damages, thus guaranteeing the reliability and stability of the portable solar charger of the embodiment.

Optionally, the power output device 4 is a junction box within which an integrated circuit board is arranged for controlling the electric energy converted by the thin-film solar cell assembly so that the output voltage meets the requirements of the load. The junction box is provided with at least one USB interface 41 for connecting with the load. The load can be mobile devices such as a mobile phone, a tablet computer, a notebook computer, a smart watch, a battery pack and the like.

For ease of use, the integrated circuit board of this embodiment is also provided with at least one indicator lamp which is capable of indicating sunlight intensity and which is preferably an LED indicator lamp. In this embodiment, the LED indicator lamp is set to: emit red light when the sunlight is scarce; emit green light when the sunlight is sufficient and the load can be directly charged; and be off when the solar charger is turned off or there is no power left for charging the load, indicating that no power is being output. It should be noted that the indicating mode of the indicator lamp of the present application is not limited to the above-mentioned mode, and the indicating mode and result of the indicator lamp can be adjusted according to the actual needs of a user.

In an embodiment, the wire 5 is located between the third flexible protection film layer and the first flexible protection film layer 31 and penetrates the adhesive bonding layer 311 and the lower surface layer 312 to connect to the junction box. Optionally, the wire 5 is preferably a tinned woven copper strip.

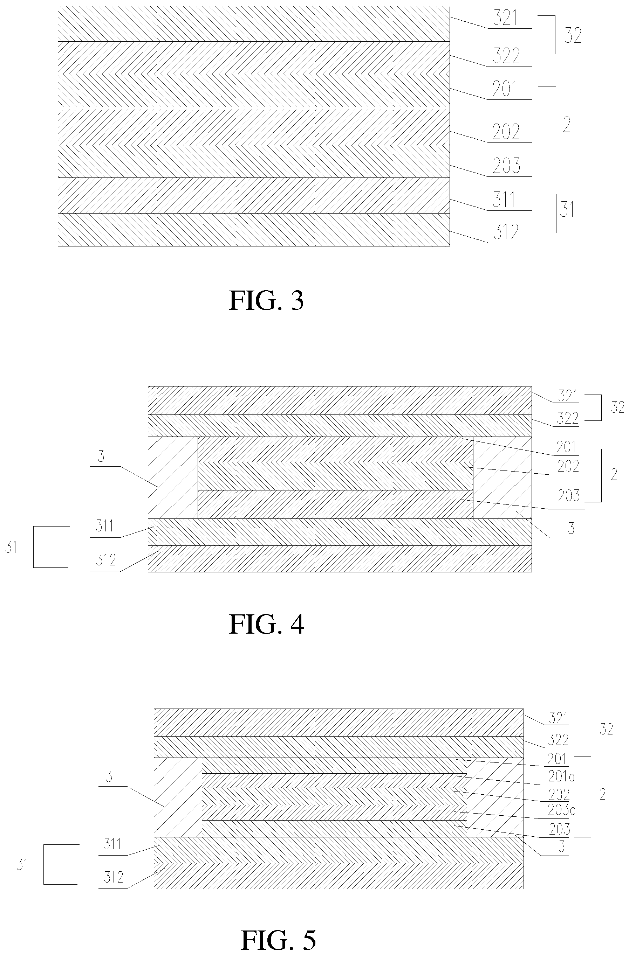

As an alternative embodiment of the present application, as shown in Fig. 4 or 5, the charger body 1 is formed through packaging by a first flexible protection film layer 31 which can be folded and curled. The first flexible protection film layer 31 includes, sequentially and from the top to the bottom, an adhesive bonding layer 311 and a lower surface layer 312. The adhesive bonding layer 311 is a hot melt adhesive layer such as an EVA layer, and the lower surface layer 312 is made of an opaque, flexible and waterproofed material such as waterproof cloth. Alternatively, the lower surface layer 312 is made of a transparent, waterproof, scratchproof, wear-resistant and weather-resistant material, such as an ETFE layer, ECTFE layer, or other materials that can meet such performance requirements.

The thin-film solar cell assembly 2 consists of one or more CIGS thin-film solar cells. Multiple CIGS thin-film solar cells are connected through wires 5, and can be connected in series and/or in parallel according to actual needs. As shown in Fig. 4, each CIGS thin-film solar cell includes, sequentially and from the top to the bottom, a water barrier film 201, a CIGS thin-film solar cell chip 202, and a water barrier film 203. The CIGS thin-film solar cell chip 202 and the water barrier films 201 and 203 are packaged into one piece. As an alternative embodiment, as shown in Fig. 5, the CIGS thin-film solar cell includes, sequentially and from the top to the bottom, a water barrier film 201, an adhesive bonding layer 201a, a CIGS thin-film solar cell chip 202, an adhesive bonding layer 203a and a water barrier film 203. The CIGS thin-film solar cell chip 202 and the water barrier film 201, the adhesive bonding layer 201a, the adhesive bonding layer 203a and the water barrier film 203 are packaged into one piece. The specific structure of each CIGS thin-film solar cell can be determined according to the specific CIGS thin-film solar cell chip. The CIGS thin-film solar cell per se is flexible, has high conversion efficiency for converting solar energy into electric energy and the weight thereof is low. The CIGS thin-film solar cell chip 202 has good flexibility, can be folded and curled, and will not be damaged after being folded or curled. The water barrier films 201 and 203 arranged respectively on the upper side and lower side of the CIGS thin-film solar cell chip 202 are waterproofed and electrically insulated. The water barrier films may be made of hot melt adhesives and are sticky. In an embodiment, the CIGS thin-film solar cell may have a rectangular or square shape. The thin-film solar cell assembly 2 is fixed to the center portion of the expanded first flexible protection film layer 31 through the adhesive bonding layer 311 of the first flexible protection film layer 31.

After the thin-film solar cell assembly 2 is fixed to the center portion of the expanded first flexible protection film layer, a windowed flexible protection film layer 3 is laid. The windowed flexible protection film layer has a window at the center portion thereof. In theory, the area of the window is preferably the same as that of the thin-film solar cell assembly 2, so as to sufficiently expose the thin-film solar cell assembly 2, thereby generate electric energy upon irradiation by the sun. If the area of the window is larger than the area of the thin-film solar cell assembly 2, there will be a gap between the windowed flexible protection film layer 3 and the thin-film solar cell assembly 2, adversely affecting the appearance. If the area of window is smaller than the area of the thin-film solar cell assembly 2, the windowed flexible protection film layer 3 will block the thin-film solar cell assembly 2, adversely affecting the power generation efficiency and reducing the power generation capacity. The windowed flexible protection film layer 3 is opaque, and can be made of waterproof cloth. Of course, the windowed flexible protection film layer 3 can otherwise be made of ETFE, ECTFE or other suitable materials.

A second flexible protection film layer 32, which is a transparent flexible protection film layer, is arranged on the thin-film solar cell assembly 2 and the windowed flexible protection film layer 3. The second flexible protection film layer 32 includes, sequentially and from the top to the bottom, an upper surface layer 321 and an adhesive bonding layer 322. The upper surface layer 321 is preferably made of a transparent, waterproof, scratchproof, wear-resistant and weather-resistant material, such as an ETFE layer. The upper surface layer 321 can otherwise be made of an ECTFE layer or other materials featured by transparent, waterproof, scratchproof, wear-resistant and weather-resistant. The adhesive bonding layer 322 is preferably a hot melt adhesive layer such as an EVA layer. The upper surface layer of the second flexible protection film layer has a plurality of recesses so as to reduce the reflection of sunlight and improve the efficiency of conversion of solar energy to electric energy.

Optionally, the area of the second flexible protection film layer 32 is at least greater than the surface area of the thin-film solar cell assembly 2 so as to be sufficiently bonded to the windowed flexible protection film layer 3 in order to protect the thin-film solar cell assembly and its electrical connection components, such as a junction box, a wire, etc., from water, scratch, wear and the like. The area of the second flexible protection film layer 32 may be substantially same as the surface area of the first flexible protection film layer. Optionally, the second flexible protection film layer may extend to wrap and package around the charger body to enhance the sealing property of the solar charger.

As an alternative embodiment, the windowed flexible protection film layer can be omitted, and the second flexible protection film layer 32 is directly laid on the thin-film solar cell assembly 2 and directly fixed to the lower surface layer 312 of the first flexible protection film layer 31 by the adhesive bonding layer 322. Or alternatively, after the second flexible protection film layer 32 is fixed to the lower surface layer 312 of the first flexible protection film layer 31 by the adhesive bonding layer 322, the windowed flexible protection film layer is laid on the second flexible protection film layer 32. In the latter case in which the windowed flexible protection film layer is used, the area of the second flexible protection film layer may be slightly larger than the surface area of the thin-film solar cell assembly 2, and the portion of the second flexible protection film layer 32 that goes beyond the surface area of the thin-film solar cell assembly 2 can be adhesively fixed between the third flexible protection film layer 3 and the first flexible protection film layer 31. It will be readily understood that when the second flexible protection film layer 32 is fixed to the solar cell assembly 2 and the first flexible protection film layer 31 by the adhesive bonding layer(s), the adhesive bonding portion of the second flexible protection film layer 32 and the lower surface layer 312 of the first flexible protection film layer 31 can be one of the adhesive bonding layers 322 and 311, so as to avoid the adhesive bonding layer being too thick.

With respect to the above embodiment, when a windowed flexible protection film layer is used, the wire 5 is arranged between the windowed flexible protection film layer and the first flexible protection film layer 31, and penetrates the adhesive bonding layer 311 and the lower surface layer 312 to connect to the junction box.

When the windowed flexible protection film layer is omitted, the wire 5 may be arranged between the transparent flexible protection film layer and the first flexible protection film layer 31 and penetrate the adhesive bonding layer 311 and the lower surface layer 312 to connect to the junction box.

Optionally, the wire 5 is preferably a tinned woven copper strip.

The arrangement of the power output device 4 and the LED may be determined according to that described with respect to the above-mentioned embodiment.

In addition, the charger body 1 is provided with at least one through hole 11 for hanging and connecting. In particular, in an embodiment, the number of the through holes 11 is four, the four through holes 11 are arranged respectively on the four corners of the charger body 1. By the arrangement of the through hole 11, a user can easily hang the portable solar charger provided by the embodiment onto a bag carried with the user, such as a backpack, a satchel, and the like. Of course, by means of the through hole 11, the portable solar charger of the embodiment can also be hanged and connected to a fixture positioned at a place where the sunlight condition is better.

Obviously, the above-mentioned embodiments are only examples for clearly illustrating this application and are not intended to limit the application. For those skilled in the art, other different forms of changes or modifications can be made based on the above description. The embodiments described herein are not provided by an exhaustive way. Changes or modifications that can be conceived from the embodiments are also within the protection scope of the present invention.

### Industrial Applicability

This application provides a solar charger which employs a thin-film solar cell assembly and can improve the conversion efficiency of converting solar energy into electric energy. The thin-film solar cell assembly fixed to the inner surface of the charger body per se is flexible and low in weight, so that the portable solar charger of this application can be folded and curled, and thus easy to take along. The thin-film solar cell assembly can be protected from damages caused by moisture, high temperature and ultraviolet light as well as mechanical and chemical damages, thus guaranteeing the reliability and stability of the solar charger.

## Claims

1. A solar charger comprising:
a charger body (1) formed by a first flexible protection film layer (31) through packaging;
a thin-film solar cell assembly fixedly arranged on an inner surface of the expanded charger body (1);
a power output device (4) configured to output the electric energy converted by the thin-film solar cell assembly; and
a wire (5) configured for connecting the thin-film solar cell assembly and the power output device;
wherein a second flexible protection film layer (32) is packaged on the thin-film solar cell assembly and comprises, sequentially and from the top to the bottom, an upper surface layer (321) and an adhesive bonding layer (322), and wherein a third flexible protection film layer is packaged on the remaining area of the inner surface of the expanded charger body expect for the area occupied by the thin-film solar cell assembly, and comprises, sequentially and from the top to the bottom, an upper surface layer, an adhesive bonding layer and a lower surface layer.

2. The solar charger according to claim 1, wherein the first flexible protection film layer (31) comprises, sequentially and from the top to the bottom, an adhesive bonding layer (311) and a lower surface layer (312).

3. The solar charger according to claim 2, wherein the upper surface layer is an ETFE layer, the lower surface layer is a waterproof cloth, and the adhesive bonding layer is an EVA layer.

4. The solar charger according to any one of claims 1-3, wherein the thickness of the upper surface layer ranges from 0.01 to 0.2 mm.

5. The solar charger according to any one of claims 1-3, wherein the thickness of the adhesive bonding layer ranges from 0.2 to 0.3 mm.

6. The solar charger according to any one of claims 1-3, wherein the thickness of the lower surface layer ranges from 0.1 to 0.2 mm.

7. The solar charger according to claim 1, wherein the power output device (4) comprises a junction box within which an integrated circuit board is arranged for controlling the electric energy converted by the thin-film solar cell assembly so that the output voltage of the solar charger meets the requirements of a load, and wherein the junction box is provided with at least one USB interface (41) for connecting with the load.

8. The solar charger according to claim 7, wherein the integrated circuit board is provided with at least one indicator lamp which is capable of indicating sunlight intensity.

9. The solar charger according to claim 2, wherein the wire is located between the first flexible protection film layer (31) and the third flexible protection film layer and penetrates the adhesive bonding layer (311) and the lower surface layer (312) of the first flexible protection film layer (31) to connect to the power output device.

10. The solar charger according to any one of claims 1-3, wherein the thin-film solar cell assembly comprises at least one CIGS thin-film solar cell, and the CIGS thin-film solar cell comprises, sequentially and from the top to the bottom, a water barrier film, a CIGS thin-film solar cell chip and a water barrier film.

11. The solar charger according to any one of claims 1-3, wherein at least one through hole (11) is arranged on the charger body for hanging and connecting.

12. A solar charger comprising:
a charger body (1) formed by a first flexible protection film layer (31);
a thin-film solar cell assembly (2) arranged on an inner surface of the expanded first flexible protection film layer;
a power output device (4) configured to output the electric energy converted by the thin-film solar cell assembly;
a wire (5) configured for connecting the thin-film solar cell assembly and the power output device; and
a transparent flexible protection film layer (32) configured to cover at least an upper surface of the thin-film solar cell assembly and fixed to the first flexible protection film layer.

13. The solar charger according to claim 12, further comprising:
a windowed flexible protection film layer (3) provided with a window in the middle thereof to expose the upper surface of the thin-film solar cell assembly;
the portion of the windowed flexible protection film layer other than the window is fixed on the first flexible protection film layer, and the transparent flexible protection film layer (32) is arranged to cover the upper surface of the thin-film solar cell assembly and is fixed on the windowed flexible protection film layer; or
the windowed flexible protection film layer is configured to fix the portion of the transparent flexible protection film layer extending beyond the upper surface of the thin-film solar cell assembly between the windowed flexible protection film layer and the first flexible protection film layer (31).

14. The solar charger according to claim 12, wherein the first flexible protection film layer comprises, sequentially and from the top to the bottom, an adhesive bonding layer (311) and a lower surface layer (312), wherein the transparent flexible protection film layer comprises, sequentially and from the top to the bottom, an upper surface layer (321) and an adhesive bonding layer (322), and wherein the transparent flexible protection film layer is fixed on the lower surface layer (312) of the first flexible protection film layer by the adhesive bonding layer (322) or the adhesive bonding layer (311).

15. The solar charger according to claim 13, wherein the first flexible protection film layer comprises, sequentially and from the top to the bottom, an adhesive bonding layer (311) and a lower surface layer (312), wherein the transparent flexible protection film layer comprises, sequentially and from the top to the bottom, an upper surface layer (321) and an adhesive bonding layer (322);
wherein the windowed flexible protection film layer is fixed on the lower surface layer (312) of the first flexible protection film layer by the adhesive bonding layer (311) of the first flexible protection film layer, and the transparent flexible protection film layer (32) is fixed on the thin-film solar cell assembly and the windowed flexible protection film layer by the adhesive bonding layer (322); or
wherein the transparent flexible protection film layer (32) is fixed on the thin-film solar cell assembly and the lower surface layer (312) of the first flexible protection film layer by the adhesive bonding layer (322), and the portion of the transparent flexible protection film layer (32) extending beyond the upper surface of the thin-film solar cell assembly is fixed between the windowed flexible protection film layer and the first flexible protection film layer.

16. The solar charger according to claim 14 or 15, wherein the upper surface layer of the transparent flexible protection film layer is an ETFE layer or ECTFE layer, the lower surface layer of the first flexible protection film layer and a windowed flexible protection film layer are waterproof cloths, the adhesive bonding layers of the first flexible protection film layer and the transparent flexible protection film layer are EVA layers, and the upper surface layer of the transparent flexible protection film layer is a layer provided with a plurality of recesses.

17. The solar charger according to claim 14 or 15, wherein the thickness of the upper surface layer of the transparent flexible protection film layer ranges from 0.01 to 0.2 mm, the thickness of the adhesive bonding layer of the transparent flexible protection film layer ranges from 0.2 to 0.3 mm, the thickness of the adhesive bonding layer of the first flexible protection film layer ranges from 0.2 to 0.3 mm, the thickness of the lower surface layer of the first flexible protection film layer ranges from 0.1 to 0.2 mm, and the thickness of the windowed flexible protection film layer ranges from 0.1 to 0.2 mm.
